Europäisches Patentamt

European Patent Office

Office européen des brevets

(19)

(11) Numéro de publication : **0 501 862 B1**

(12) **FASCICULE DE BREVET EUROPEEN**

(45) Date de publication du fascicule du brevet :
25.01.95 Bulletin 95/04

(51) Int. Cl.[6] : **H01S 3/19, H01L 33/00**

(21) Numéro de dépôt : **92400465.8**

(22) Date de dépôt : **24.02.92**

(54) **Procédé de réalisation d'un laser à semiconducteur à ruban enterré, utilisant une gravure sèche pour former ce ruban et laser obtenu par ce procédé.**

(30) Priorité : **26.02.91 FR 9102272**

(43) Date de publication de la demande :
**02.09.92 Bulletin 92/36**

(45) Mention de la délivrance du brevet :
**25.01.95 Bulletin 95/04**

(84) Etats contractants désignés :
**DE FR GB**

(56) Documents cités :
**EP-A- 0 261 943**
**EP-A- 0 292 390**
**APPLIED PHYSICS LETTERS. vol. 57, no. 18, 29 Octobre 1990, NEW YORK US, pages 1864 - 1866; Y.L.WANG et al.: 'Buried-heterostructure lasers fabricated by in situ processing techniques'**
**PATENT ABSTRACTS OF JAPAN vol. 13, no. 330 (E-793)(3678) 25 Juillet 1989 & JP-A-1 094 690**
**APPLIED PHYSICS LETTERS. vol. 56, no. 17, 23 Avril 1990, NEW YORK US,pages 1641-1642; T. MATSUI et al.: '1.5 um GaInAsP/InP buried-heterostructure laser diode fabricated by reactive ion etching using a mixture of ethane and hydrogen'**

(56) Documents cités :
**ELECTRONICS LETTERS. vol. 23, no. 10, 7 Mai 1987, ENAGE GB pages 485 - 487; P.SANSO-NETTI ET AL.: 'Low-treshold GaAs/GaAlAs buried heterostructure laser with an ion-beam-etched quarter ring cavity'**
**APPLIED PHYSICS LETTERS. vol. 59, no. 1, 1 Juillet 1991, NEW YORK US pages 22 -24; N.BOUADMA ET AL: 'Over 245 mW 1.3 um buried ridge stripe laser diodes on n-substrate fabricated by the reactive ion beam etching technique.'**
**Solid State Technology, Janvier 1983, pages 99 - 101; Materials Processing, Theory and Practices, Vol. 4, North-Holland, Pays-Bas, page 147.**

(73) Titulaire : **FRANCE TELECOM**
**Etablissement autonome de droit public,**
**6, Place d'Alleray**
**F-75015 Paris (FR)**

(72) Inventeur : **Bouadma, Nouredine**
**17 rue du Val de Marne**
**F-94250 Gentilly (FR)**

(74) Mandataire : **Mongrédien, André et al**
**c/o BREVATOME**
**25, rue de Ponthieu**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un procédé de réalisation d'un laser à semiconducteur à ruban enterré dans lequel :
- on forme une hétérostructure par une première épitaxie au cours de laquelle on dépose successivement sur un substrat une première couche de confinement ayant un premier type de dopage, une couche active et une couche de protection,
- on grave la couche de protection et la couche active jusqu'à la première couche de confinement, de façon à former un ruban à partir de la couche active, et
- on enterre le ruban, par une deuxième épitaxie appelée "reprise d'épitaxie", dans une couche de semiconducteur ayant un deuxième type de dopage opposé au premier et formant une deuxième couche de confinement.

L'invention s'applique notamment au domaine des télécommunications optiques et en particulier à la fabrication de lasers semiconducteurs à double hétérostructure destinés aux liaisons par fibres optiques monomodes.

On connaît déjà différentes structures de lasers à ruban enterré.

On peut par exemple citer :
- la structure EMBH (pour "EMbedded Buried Heterostructure") à jonctions bloquantes,
- la structure FBH (pour "Flat Surface Buried Heterostructure"),
- la structure SI-PBH (pour "Semi-Insulating Planar Buried Heterostructure") à couches semi-isolantes, et
- la structure BRS (pour "Buried Ridge Stripe") à homojonctions ou à hétérojonctions.

Les procédés de croissance et les caractéristiques statiques et dynamiques de ces structures de lasers sont très variés.

Cependant, la structure BRS semble très prometteuse dans la mesure où elle nécessite seulement deux cycles d'épitaxie successifs et qu'elle est bien adaptée à toutes les techniques d'épitaxie telles que le dépôt en phase vapeur aux organométalliques (ou MOCVD pour MetalOrganic Chemical Vapour Deposition) et l'épitaxie par jets moléculaires (ou MBE pour Molecular Beam Epitaxy).

Diverses structures BRS connues sont décrites dans les documents (1) à (4) qui sont cités à la fin de la présente description et auxquels on se reportera.

On sait également que la société THOMSON CSF et le C.N.E.T. (Centre National d'Etudes des Télécommunications) étudient actuellement des lasers à structure BRS émettant à 1,3 et à 1,5 micromètre.

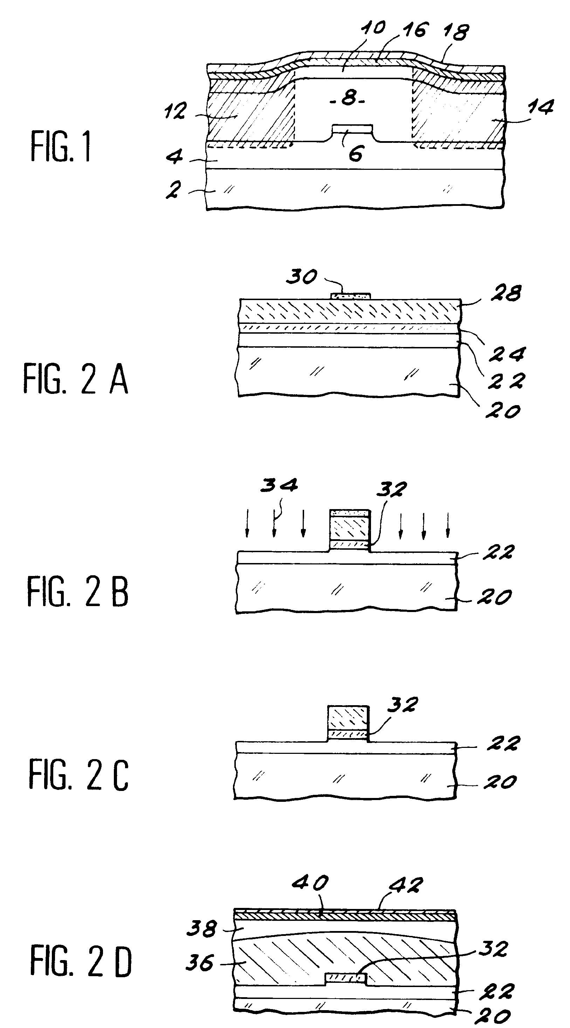

Un exemple de tels lasers à structure BRS est schématiquement représenté sur la figure 1.

La structure connue, qui est représentée sur la figure 1, est réalisée à l'aide de deux cycles d'épitaxie.

Dans un premier cycle d'épitaxie, on forme, sur un substrat 2 en InP dopé $n^+$, une première couche de confinement 4 en InP dopé n puis une couche active 6 en InGaAsP non dopé puis une couche de protection en InP dopé p, de faible épaisseur.

On grave ensuite un ruban, sur une largeur de 2 micromètres par exemple, jusqu'à la première couche de confinement 4, à l'aide d'une solution chimique à base de brome.

Un deuxième cycle d'épitaxie permet de refaire croître sur le ruban une deuxième couche de confinement 8 en InP dopé p puis une couche de contact 10 en InGaAs dopé $p^+$.

La localisation du courant électrique sur le mesa résultant de la gravure est ensuite obtenue par implantation de protons dans la couche de contact 10 et dans la deuxième couche de confinement 8, ce qui crée des régions de haute résistivité 12 et 14 de part et d'autre du ruban actif que l'on a formé.

On dépose enfin sur la couche de contact 10 une couche de platine 16 puis une couche d'or 18.

Le procédé de fabrication de la structure BRS qui a été décrite en faisant référence à la figure 1, s'il est intéressant à certains égards (notamment pour sa facilité de mise en oeuvre et sa compatibilité avec tous les procédés de croissance, surtout en phase vapeur) présente néanmoins des inconvénients.

En effet, la gravure du ruban étant réalisée par voie chimique en solution, des problèmes inhérents à cette technique se posent lors de la réalisation de cette structure, notamment sur des plaques semiconductrices épitaxiées de grande surface.

Un premier problème est la gravure latérale du ruban, ou sous-gravure, qui est caractéristique de toutes les attaques chimiques isotropes.

Etant donné la faible largeur du masque utilisé pour la gravure (2 micromètres), ce phénomène a pour conséquence de limiter à quelques centaines de nanomètres la profondeur de gravure dans le matériau pour ne pas trop réduire la largeur finale du ruban (qui vaut typiquement 1,4 micromètre).

Un deuxième problème est le manque d'uniformité de la gravure, notamment sur les grandes surfaces où, comme on l'a montré expérimentalement, la gravure chimique en solution commence initialement sur les bords de l'échantillon immergé et se propage vers le centre de cet échantillon, entraînant ainsi une variation notable de la profondeur et de la largeur du ruban entre le bord et le centre de l'échantillon.

Un troisième problème réside dans le fait que les gravures chimiques en solution sont connues pour être largement dépendantes de plusieurs paramètres extérieurs (notamment la température, l'agitation et la luminosité), ce qui a pour conséquence de rendre difficilement reproductible la structure réalisée.

La présente invention a pour but de remédier aux inconvénients précédents.

On connaît, par Electronics Letters, vol. 25, no. 22, octobre 1989, pages 1477 - 1479, un dispositif laser à semiconducteur à ruban enterré (buried ridge stripe, BRS) et un procédé pour sa réalisation dans lequel:

on forme une hétérostructure par une première épitaxie au cours de laquelle on dépose successivement sur un substrat (n-InP) une première couche de confinement (n-InP) ayant un premier type de dopage, une couche active (GaInAsP, $\lambda = 1.5\mu m$) et une couche de protection (GaInAsP, $\lambda = 1.28\mu m$),

on grave, à l'aide d'une solution chimique à base de brome la couche de protection et la couche active jusqu'à la première couche de confinement de façon à former un ruban à partir de la couche active et on enterre le ruban par une deuxième épitaxie, dans une couche (p-InGaAsP) de semiconducteur ayant un deuxième type de dopage opposé au premier et formant une deuxième couche de confinement.

On connaît aussi, par EP-A-0 292 390, un procédé de gravure anisotrope d'un matériau III-V. Selon ce procédé, le matériau subit ne gravure ionique réactive utilisant un mélange contenant, en volume, de 20 à 30% d'un gaz tel que $CH_4$, de 30 à 50% d'un gaz tel que Ar et de 20 à 50% d'hydrogène.

D'autres procédés de réalisation des lasers à hétérostructure enterrée basés sur des techniques de gravure sèche sont connus de JP-A-1-94690 et Applied Physics Letters, Vol. 57, No. 29, Octobre 1990, pages 1864-1866.

L'invention résout le problème suivant : trouver un procédé de réalisation d'un laser à semiconducteur à ruban enterré qui soit applicable sur des échantillons de grande surface, par exemple des plaquettes semiconductrices de 2 pouces (5 cm) de diamètre ou plus, permettant ainsi une production en masse du laser, avec une bonne uniformité des caractéristiques, et de ce fait une réduction du coût de ce laser.

Pour résoudre ce problème, le procédé de réalisation d'un laser à semiconducteur à ruban enterré, qui fait l'objet de la présente invention, est conforme à la revendication 1.

Ladite couche de résine est par exemple une couche de résine photosensible.

L'invention utilise ainsi les propriétés d'anisotropie, d'uniformité et de reproductibilité, qui sont spécifiques des divers procédés de gravure par voie sèche.

Grâce à l'absence d'effets de sous-gravure, le procédé objet de l'invention permet d'obtenir, avec un bon contrôle, des rubans actifs dont les largeurs sont inférieures à 1 micromètre ("rubans submicroniques"), en réduisant ainsi le courant de seuil des lasers fabriqués par ce procédé, le courant de seuil étant un paramètre très important pour plusieurs applications de l'invention, et notamment l'intégration opto-électronique.

En tant que technique de gravure sèche, on pourrait utiliser une gravure ionique réactive (ou RIE pour "Reactive Ion Etching"), une gravure par faisceaux d'ions neutres (ou IBE pour "Ion Beam Etching") ou encore une gravure par faisceaux d'ions neutres assistée chimiquement (ou CAIBE pour "Chemical Assisted Ion Beam Etching").

Cependant, dans la présente invention, la technique de gravure sèche est une gravure par faisceaux d'ions réactifs (ou RIBE pour "Reactive Ion Beam Etching"), technique qui présente des avantages par rapport aux autres techniques de gravure sèche.

C'est ainsi que, par exemple, la technique RIBE permet de contrôler de façon indépendante les divers paramètres de gravure (notamment pression, tension d'accélération des ions et angle d'incidence du faisceau d'ions), chose que ne permet pas la technique RIE.

De plus, l'utilisation, dans la présente invention, du mélange gazeux de méthane, d'argon et d'hydrogène, est bien moins toxique pour les utilisateurs et bien moins corrosif pour l'appareillage de gravure que d'autres gaz (par exemple le chlore).

Dans la présente invention, la deuxième épitaxie peut être une épitaxie en phase vapeur.

Elle peut être réalisée par la technique de dépôt chimique en phase vapeur aux organométalliques (ou MOCVD).

De préférence, le procédé objet de l'invention comprend aussi, avant la deuxième épitaxie, une attaque chimique de courte durée des couches gravées.

Selon un mode de mise en oeuvre préféré du procédé objet de l'invention, l'hétérostructure est double, la composition de la couche active étant alors différente de la composition de la première couche de confinement et de la composition de la couche de protection.

On sait en effet qu'une dcuble hétérostructure conduit à des densités de courant de seuil beaucoup plus faibles que celles auxquelles conduisent les simples hétérostructures.

Selon un mode de mise en-oeuvre particulier du procédé objet de l'invention, le substrat est en InP dopé n+, la première couche de confinement en InP dopé n, la couche active en InGaAsP, la couche de protection en InP dopé p et la deuxième couche de confinement en InP dopé p entre $10^{18}$ et $5.10^{18}$ cm$^{-3}$.

La présente invention sera mieux comprise à la lecture de la description d'exemples de réalisation donnés ci-après à titre purement indicatif et nullement limitatif, en référence aux dessins annexés, sur lesquels, outre la figure 1 déjà décrite, qui représente schématiquement un laser à ruban enterré connu, les figures 2A à 2D illustrent schématiquement diverses étapes d'un mode de mise en oeuvre particulier du procédé objet de l'invention.

Ces diverses étapes sont décrites dans ce qui suit.

On commence (figure 2A) par former une double hétérostructure en déposant successivement, par épitaxie, sur un substrat 20 en InP dopé n+ :

- une première couche de confinement 22 en InP dopé n,
- une couche active 24 en InGaAsP non dopé de 110 nm d'épaisseur,
- une couche de protection 28 en InP dopé p (par exemple par des atomes de zinc) de 100 nm d'épaisseur.

On réalise ensuite un masquage de l'hétérostructure obtenue, au moyen, par exemple, d'une résine photosensible, de façon à former, sur la couche de protection 28, un motif 30 de cette résine, de 2 micromètres de large et de 600 nm à 1 micromètre de hauteur, ce motif étant disposé selon la direction <110> de la couche de protection 28.

On réalise ensuite (figure 2B) une gravure sèche, de type RIBE, de l'hétérostructure ainsi masquée, jusqu'à la première couche de confinement 22, d'où l'obtention d'un ruban actif 32 à partir de la couche active 24 ainsi gravée.

Cette gravure est réalisée dans un bâti équipé d'une source d'ions de type Kaufman ou d'une source d'ions cyclotronique, ou source ECR (pour "Electron Cyclotronic Resonance"), ou encore d'une source RF.

Cette gravure est réalisée dans les conditions expérimentales suivantes pour une source d'ions Kaufman :

- gaz de gravure : mélange d'argon, d'hydrogène et de méthane (ce mélange permettant de graver InP, GaAs et des composés de ces derniers notamment)
- énergie du faisceau d'ions 34 : 300 eV
- densité ionique : de 0,250 à 0,550 mA/cm$^2$
- angle d'incidence de ce faisceau d'ions 34 : 20°
- pression totale : $5 \times 10^{-4}$ torr (environ $7 \times 10^{-2}$ Pa)
- débits respectifs des gaz : 10 sccm (cm$^3$ standard par minute) pour l'argon, 20 sccm pour l'hydrogène et 4 sccm pour le méthane (cette proportion des gaz pourrait changer dans le cas de l'utilisation d'autres types de sources)
- vitesse de rotation du porte-substrat : 12 tours/minute.

Etant donné que tout procédé de gravure par voie sèche est caractérisé par la création, dans le matériau gravé, de défauts induits par le faisceau ionique accéléré et que l'épaisseur de matériau perturbée est proportionnelle à l'énergie de ce faisceau (cette épaisseur étant inférieure à 20 nm pour une énergie de 300 eV), on réalise ensuite une attaque chimique légère, c'est-à-dire de courte durée (de l'ordre de 5 secondes) de la structure ainsi gravée, dans une solution non sélective dont les proportions en volume sont :

|Br(1)HBr(17)H$_2$O(35)| (1) : H$_2$O(7), à 2°C.

On effectue ensuite un contrôle de la photoluminescence du ruban obtenu et de la surface de la première couche de confinement en InP dopé n, pour s'assurer de la bonne qualité de la gravure.

On enlève ensuite le masque de résine 30 (figure 2C).

L'enlèvement de ce masque pose un problème.

En effet, l'utilisation d'un gaz réactif à base d'un hydrocarbure comme par exemple le méthane permet de graver un matériau semiconducteur tel que InP.

En contre partie, lors de la gravure, un dépôt de polymère se produit sur tout matériau autre que InP ou les dérivés de celui-ci, notamment sur le masque de résine, ce qui rend ce masque difficile à enlever avec des solvants usuels comme l'acétone par exemple.

L'utilisation d'un plasma d'oxygène pour l'enlèvement permet de résoudre ce problème mais, malheureusement, une perte de photoluminescence de InP et du composé quaternaire InGaAsP a été constatée chaque fois qu'un tel procédé d'enlèvement de la résine a été utilisé.

Pour remédier à cet inconvénient et enlever d'une façon simple le masque de résine 30 sans endommager la surface de l'hétérostructure gravée, on utilise, dans l'exemple de réalisation de l'invention, une solution d'acide fluorhydrique dans un bac à ultrasons et ce, pendant 2 minutes.

On procède ensuite à un nettoyage, à l'aide de techniques classiques, de la surface de l'hétérostructure gravée.

Pour ce faire, on réalise d'abord un nettoyage à chaud de cette surface, successivement dans le trichloréthylène, l'acétone et l'isopropanol et ce, pendant 2 minutes pour chacun de ces produits, puis on réalise une légère gravure (pendant 1 minute) de cette surface dans de l'acide sulfurique et l'on fait suivre cette gravure d'une désoxydation dans de l'acide fluorhydrique pendant 30 secondes.

On réalise ensuite (figure 2D) un deuxième cycle d'épitaxie, appelé "reprise d'épitaxie", par exemple par une technique de type MOCVD, pour faire croître sur la structure gravée une deuxième couche de confinement 36 en InP dopé p à $2 \times 10^{18}$ cm$^{-3}$ par des atomes de zinc (ce fort dopage étant destiné à limiter les courants de fuite latérale), ce qui enterre le ruban actif 32, puis une couche de contact 38 en InGaAs dopé p$^+$ sur cette deuxième couche de confinement 36.

Le dopage de la couche de contact 38 est réalisé avec des atomes de zinc à $1 \times 10^{19}$ cm$^{-3}$.

On dépose ensuite sur cette couche de contact 38 une couche de platine 40 que l'on recuit à 450°C pendant 2 mn puis, sur cette couche 40, une couche d'or 42.

On a démontré l'uniformité du procédé de gravure RIBE dans les conditions expérimentales décrites plus haut.

Pour ce faire, on a gravé des rubans parallèles de 2 micromètres de large et de 500 nm de profondeur sur un échantillon de InP de 50 mm de diamètre.

En traçant les variations de la largeur et de la profondeur de chaque ruban en fonction de sa position sur l'échantillon, on constate qu'une très bonne uniformité est obtenue sur toute la surface de cet échantillon et que la largeur du ruban après gravure est quasiment égale à la largeur de ce ruban avant gravure (de l'ordre de 2 micromètres).

Ceci autorise la réalisation de rubans submicroniques avec un très bon contrôle.

Par ailleurs, on a réalisé des structures lasers de type BRS à l'aide du procédé de l'exemple décrit plus haut et l'on a constaté que ces lasers présentaient des performances supérieures à celles que l'on obtient avec des structures lasers de type BRS fabriquées par des procédés connus.

Les caractéristiques puissance de sortie/courant injecté en impulsion (P/I) de plusieurs structures lasers BRS fabriquées comme dans l'exemple décrit plus haut ont une bonne uniformité en termes de courant de seuil et de rendement quantique externe.

On a également étudié la caractéristique en continu (P/I) de l'un de ces lasers et l'on a noté une puissance maximale de sortie supérieure à 90 mW, ce qui témoigne d'une bonne efficacité des jonctions électriques en InP situées de chaque côté du ruban et confirme la bonne qualité du procédé de gravure utilisé.

De plus, le comportement dynamique de ces lasers a été mis en évidence par la mesure de leurs réponses en fréquence.

Une bande passante à -3 dB de 17 GHz a été mesurée.

On a d'ailleurs constaté que la courbe correspondant à cette bande passante était plane ("roll off" indiscernable), ce qui démontre que les éléments parasites de la structure sont faibles (capacité parasite de l'ordre de 5 à 6 pF et résistance-série de l'ordre de 1,5 ohm).

Ces faibles valeurs de la résistance-série et de la capacité parasite sont essentiellement dûes au fort dopage des couches en InP dopé p et en InGaAs dopé $p^+$ (respectivement $2\times10^{18}$ et $1\times10^{19}$ cm$^{-3}$).

Bien entendu, la couche active 24 pourrait avoir une structure de puits quantiques au lieu d'être faite d'un seul matériau semiconducteur (InGaAsP dans l'exemple décrit).

Les documents (1) à (4) dont il est question au début de la présente description sont les suivants :

(1) article de R. Blondeau et al., Electronics Letters, vol.20, p.850 et 851, 11 octobre 1984

(2) FR-A-2587852, "Procédé de réalisation d'un laser à semiconducteur à ruban enterré avec ou sans réseau de diffraction et laser obtenu par ce procédé", G. Chaminant, J. Charil, J.C. Bouley - voir aussi US-A-4737237

(3) Demande de brevet français n° 8607064 du 16 mai 1986, Laser à semiconducteur à réaction distribuée et à longueur d'onde continûment accordable, J.C. Bouley, P. Correc - voir aussi US-A-4802187

(4) FR-A-2637743, Laser à semiconducteur à ruban enterré et à couche bloquante et procédé de fabrication de ce laser, J.C. Bouley, C. Kazmierski

## Revendications

1. Procédé de réalisation d'un laser à semiconducteur à ruban enterré dans lequel :

   - on forme une hétérostructure par une première épitaxie au cours de laquelle on dépose successivement sur un substrat (20) une première couche de confinement (22) ayant un premier type de dopage, une couche active (24) et une couche de protection (28),
   - on grave la couche de protection (28) et la couche active (24) jusqu'à la première couche de confinement (22), de façon à former un ruban (32) à partir de la couche active (24), et
   - on enterre le ruban (32), par une deuxième épitaxie, dans une couche (36) de semiconducteur ayant un deuxième type de dopage opposé au premier et formant une deuxième couche de confinement, ce procédé étant caractérisé en ce qu'une couche de contact (38) ayant le même type de dopage que la deuxième couche de confinement (36) est formée sur cette dernière, en ce qu'une couche conductrice (40) est formée sur la couche de contact (38), en ce que la couche de protection (28) et la couche active (24) sont gravées par la technique de gravure par faisceaux d'ions réactifs, au moyen d'un mélange gazeux d'argon, de méthane et d'hydrogène, en ce que la gravure par faisceaux d'ions réactifs comprend une étape préalable de masquage, par une couche de résine (30), d'une partie de la couche de protection (28) qui est au-dessus de la zone de la couche active (24) correspondant au ruban (32) à former, et en ce que l'on enlève la résine au moyen d'acide fluorhydrique dans un bac à ultrasons, après la gravure.

2. Procédé selon la revendication 1, caractérisé en ce que la deuxième épitaxie est une épitaxie en phase vapeur.

3. Procédé selon la revendication 2, caractérisé en ce que la deuxième épitaxie est réalisée par la technique de dépôt chimique en phase vapeur aux organométalliques.

**4.** Procédé selon l'une quelconque des revendications 1 à 3, caractérisé en ce qu'il comprend en outre, avant la deuxième épitaxie, une attaque chimique de courte durée des couches gravées (24, 26, 28).

**5.** Procédé selon l'une quelconque des revendications 1 à 4, caractérisé en ce que l'hétérostructure est double, la composition de la couche active (24) étant alors différente de la composition de la première couche de confinement (22) et de la composition de la couche de protection (28).

**6.** Procédé selon la revendication 5, caractérisé en ce que le substrat (20) est en InP dopé n+, la première couche de confinement (22) en InP dopé n, la couche active (24) en InGaAsP, la couche de protection (28) en InP dopé p et la deuxième couche de confinement (36) en InP dopé p entre $10^{18}$ et $5.10^{18}$ cm$^{-3}$.

**Patentansprüche**

**1.** Verfahren zur Herstellung eines Halbleiterlasers mit vergrabener Streifenstruktur, das darin besteht:
- eine Heterostruktur zu bilden durch eine erste Epitaxie, in deren Verlauf man nacheinander auf einem Substrat (20) eine erste Einschließungsschicht (22) mit einem ersten Dotierungstyp, eine aktive Schicht (24) und eine Schutzschicht (28) abscheidet,
- die Schutzschicht (28) und die aktive Schicht (24) bis auf die erste Einschließungsschicht (22) zu ätzen, um einen Streifen (32) zu bilden aus der aktiven Schicht (24), und
- den Streifen (32) durch eine zweite Epitaxie zu vergraben in einer Halbleiterschicht (36) mit einem zweiten, dem ersten entgegengesetzten Dotierungstyp und eine zweite Einschließungsschicht bildend,
wobei dieses Verfahren **dadurch gekennzeichnet** ist, daß eine Kontaktschicht (38) mit dem gleichen Dotierungstyp wie die zweite Einschließungsschicht (36) gebildet wird auf dieser letzteren, dadurch daß eine leitende Schicht (40) gebildet wird auf der Kontaktschicht (38), dadurch daß die Schutzschicht (28) und die aktive Schicht (24) geätzt werden durch reaktives Ionenätzen mittels einer Gasmischung aus Argon, Methan und Wasserstoff, dadurch daß das Ätzen mittels reaktivem Ionenstrahl einen vorhergehenden Maskierungsschritt, mittels einer Harzschicht (30), eines Teils der Schutzschicht (28) umfaßt, die sich über der Zone der aktiven Schicht (24) befindet, dem zu bildenden Streifen (32) entsprechend, und dadurch, daß man das Harz entfernt mittels Flußsäure in einem Ultraschallbehälter, nach dem Ätzen.

**2.** Verfahren nach Anspruch 1, dadurch gekennzeichnet, daß die zweite Epitaxie Gasphasenepitaxie ist.

**3.** Verfahren nach Anspruch 2, dadurch gekennzeichnet, daß die zweite Epitaxie durchgeführt wird mittels der Metallorganica-CVD-Technik.

**4.** Verfahren nach einem der Ansprüche 1 bis 3, dadurch gekennzeichnet, daß es außerdem, vor der zweiten Epitaxie, einen kurzen chemischen Angriff der geätzten Schichten (24, 26, 28) umfaßt.

**5.** Verfahren nach einem der Ansprüche 1 bis 4, dadurch gekennzeichnet, daß die Heterostruktur doppelt ist, wobei die Zusammensetzung der aktiven Schicht (24) dann unterschiedlich ist von der Zusammensetzung der ersten Einschließungsschicht (22) und von der Zusammensetzung der Schutzschicht (28).

**6.** Verfahren nach Anspruch 5, dadurch gekennzeichnet, daß das Substrat (20) aus n$^+$-dotiertem InP ist, die erste Einschließungsschicht (22) aus n-dotiertem InP, die aktive Schicht (24) aus InGaAsP, die Schutzschicht (28) aus p-dotiertem InP und die zweite Einschließungsschicht (36) aus InP, p-dotiert zwischen $10^{18}$ und $5.10^{18}$cm$^{-3}$.

**Claims**

**1.** Process for producing a buried stripe semiconductor laser in which:
a heterostructure is formed by a first epitaxy during which successive deposition takes place on a substrate (20) of a first confinement layer (22) having a first doped type, an active layer (24) and a protection layer (28),
the protection layer (28) and the active layer (24) are etched down to the first confinement layer (22), so as to form a stripe (32) from the active layer (24) and
the stripe (32) is buried by a second epitaxy in a semiconductor layer (36) having a second doping type opposite to the first and forming a second confinement layer,
said process being characterized in that a contact layer (38) having the same doping type as the second confinement layer (36) is formed on the latter, in that a conductive layer (40) is formed on the contact layer (38), in that the protection layer (28) and the active layer (24) are etched by reactive ion beam etching procedure using a gaseous mixture of argon, methane and hydrogen and in that the reactive ion beam etching comprises a prior masking stage, by a resin layer (30), of part of the protection layer (28) which is above the zone of the active layer (24) corresponding to the stripe (32) to be formed and in that the resin is removed by means of hydrofluoric acid in an ultrasonic tank following etching.

2. Process according to claim 1, characterized in that the second epitaxy is a vapour phase epitaxy.

3. Process according to claim 2, characterized in that the second epitaxy is performed by metalorganic chemical vapour phase deposition.

4. Process according to any one of the claims 1 to 3, characterized in that it also comprises, before the second epitaxy, a brief etching of the etched layers (24, 26, 28).

5. Process according to any one of the claims 1 to 4, characterized in that use is made of a double heterostructure, the composition of the active layer (24) then being different from the composition of the first confinement layer (22) and the composition of the protection layer (28).

6. Process according to claim 5, characterized in that the substrate (20) is of $n^+$ doped InP, the first confinement layer (22) of n doped InP, the active layer (24) of InGaAsP, the protection layer (28) of p doped InP and the second confinement layer (36) of InP p doped between $10^{18}$ and $5.10^{18}$ cm$^{-3}$.

EP 0 501 862 B1

FIG. 1

FIG. 2 A

FIG. 2 B

FIG. 2 C

FIG. 2 D

8